# EUROPEAN PATENT APPLICATION

(11) **EP 4 177 374 A1**
(43) Date of publication of application: **10.05.2023**
(21) Application number: 21838706.6
(22) Date of filing: 02.06.2021
(51) Int. Cl.: C23C 16/513, C08G 77/06

(54) **SUPER-HYDROPHOBIC MEMBRANE LAYER, PREPARATION METHOD THEREFOR, AND PRODUCT THEREOF**

(30) Priority: 06.07.2020 CN 202010641141
(71) Applicant: Jiangsu Favored Nanotechnology Co., Ltd., Wuxi, Jiangsu 214000 (CN)
(72) Inventor: ZONG, Jian, Wuxi, Jiangsu 214000 (CN); TAO, Yongqi, Wuxi, Jiangsu 214000 (CN); LI, Fuxing, Wuxi, Jiangsu 214000 (CN)
(74) Representative: Mewburn Ellis LLP
(86) International application number: PCT/CN2021/098020
(87) International publication number: WO 2022/007555

(57) **Abstract**

A super-hydrophobic film layer, a preparation method thereof, and a product thereof are provided, the preparation method includes using a siloxane monomer as a reaction material to form a super-hydrophobic film layer on a surface of a substrate by a plasma enhanced chemical vapor deposition.

## Description

### TECHNICAL FIELD

The present disclosure relates to the field of surface modification method, and more particularly, to a super-hydrophobic film layer, a preparation method thereof, and a product thereof.

### BACKGROUND

Hydrophobicity performance generally requires that a water contact angle of a material surface is greater than 90°, while super hydrophobicity performance generally requires that a water contact angle of a material surface is not less than 150°.

In nature, there are many super-hydrophobic phenomena. For example, when rain drops fall on lotus leaves or rice leaves, rain drops can automatically slide down along surfaces of lotus leaves or rice leaves with taking away some dust attached to the surfaces.

A super-hydrophobic film layer is usually prepared on a surface of a substrate to achieve a super-hydrophobic performance, it has great application prospects in the fields of anti-fog, anti-corrosion, self-cleaning and anti-ice, such as solar cells, display screen waterproof, and building glass self-cleaning, and so on.

At present, a method for preparing a super-hydrophobic film layer generally includes two steps. Firstly, a surface is roughened to a certain level by sandblasting, etching or electroplating. Then, a layer of low surface energy material is modified by liquid phase methods such as spraying, spin coating or soaking, so that the super-hydrophobic film layer can be formed to achieve a super-hydrophobic performance. These preparation methods are generally complicated, and organic solvents used in the preparation process may cause adverse effects on environment and operators, such as the liquid phase fluorosilane series. In addition, a utilization rate of raw materials is low. These factors are not conducive to a large-scale industrial preparation of super-hydrophobic film layers.

Referring to a Chinese patent CN107365088A which discloses a preparation method of a super-hydrophobic film on a glass surface. This disclosure uses a sol-gel method to coat a surface of a substrate with sodium borosilicate glass film. Then, a nano-size porous structure is formed through a heat treatment and a buffer acid etching solution. Finally, the substrate is soaked in a fluorosilane solution under a pressure less than 5×10⁻²Pa for 15-30min. A film is formed after the substrate is taken out and dried. The method provided by the disclosure is not only complicated, but also requires a heat treatment temperature of more than 500°C when preparing the nano-size porous structure. Obviously, the treatment temperature makes a limitation, which narrows the application field of the preparation method.

### SUMMARY

According to a super-hydrophobic film layer, a preparation method thereof and a product thereof provided by the present disclosure, the present disclosure has an advantage that the super-hydrophobic film layer can be prepared by the preparation method with a simplified process, which is suitable for a large-scale industrial production.

According to a super-hydrophobic film layer, a preparation method thereof and a product thereof provided by the present disclosure, the present disclosure has an advantage that the super-hydrophobic film layer does not depend on large organic solvents in the preparation method, which is conducive to environmental protection and a safe working environment for operators.

According to a super-hydrophobic film layer, a preparation method thereof and a product thereof provided by the present disclosure, the present disclosure has an advantage that the super-hydrophobic film layer prepared by the preparation method is provided with a high transparency, and the super-hydrophobic film layer formed on a substrate does not have too much influence on a light transmittance of the substrate.

According to a super-hydrophobic film layer, a preparation method thereof and a product thereof provided by the present disclosure, the present disclosure has an advantage that a thickness of the super-hydrophobic film layer prepared by the preparation method is controllable at a nanometer level. Therefore, the preparation method is suitable for preparing the super-hydrophobic film layer in the field with high precision.

According to a super-hydrophobic film layer, a preparation method thereof and a product thereof provided by the present disclosure, the present disclosure has an advantage that the super-hydrophobic film layer can be prepared at a low temperature by the preparation method, which reduces a possibility of damage to the substrate due to high temperature on the one hand, and broadens an application scope of the preparation method on the other hand.

According to an aspect of the present disclosure, a product with a super-hydrophobic film layer. The super-hydrophobic film layer is formed on a surface of the product by a plasma enhanced chemical vapor deposition using a siloxane monomer as a reaction raw material.

According to an embodiment of the present disclosure, the product includes one or more selected from a group consisting of: an electronic product, a silk product, a metal product, a glass product, a ceramic product and a plastic product.

According to an embodiment of the present disclosure, a light transmittance of the product before the formation of the super-hydrophobic film layer and after the formation of the super-hydrophobic film layer changes by no more than 1%.

According to an embodiment of the present disclosure, an inert gas is introduced and a plasma discharge is turned on to bombard the surface of the product with plasma before forming the super-hydrophobic film layer.

According to an embodiment of the present disclosure, in a process of forming the super-hydrophobic film layer, introducing an inert gas as an auxiliary gas.

According to an embodiment of the present disclosure, in a process of forming the super-hydrophobic film layer, an ICP source is used as a plasma source.

According to an embodiment of the present disclosure, in a process of forming the super-hydrophobic film layer, a bias voltage is applied to an environment where the product is placed.

According to an embodiment of the present disclosure, in a process of forming the super-hydrophobic film layer, the product is placed on a rotary frame so as to be movable during a coating process.

According to an embodiment of the present disclosure, in a process of forming the super-hydrophobic film layer, the siloxane monomer is a hydrocarbon siloxane compound, and a methyl dangling bond is formed on a surface of a substrate during a reaction process to reduce a surface energy of the surface of the substrate.

According to an embodiment of the present disclosure, the siloxane monomer includes one or more selected from a group consisting of: hexamethyldisiloxane, tetramethyldisiloxane, hexaethyldisiloxane, 1,1,3,3-tetramethyldisiloxane, tetramethoxysilane, tetraethoxysilane, tetrapropoxysilane, allyl trimethoxysilane, trimethylcyclotrisiloxane, hexamethylcyclotrisiloxane, octamethylcyclotetrasiloxane, tetramethyltetravinylcyclotetrasiloxane, dodecylcyclohexasiloxane, and decamethylcyclopentasiloxane.

According to an embodiment of the present disclosure, a water contact angle of the super-hydrophobic film layer is greater than 150°.

According to an aspect of the present disclosure, a method for preparing a super-hydrophobic film layer is provided, the preparation method includes: introducing a siloxane monomer serving as a reaction raw material into a PECVD coating device to form a super-hydrophobic film layer on a surface of a substrate by a plasma enhanced chemical vapor deposition.

### BRIEF DESCRIPTION OF THE DRAWINGS

FIG. 1 is a schematic diagram of a water contact angle of a glass sheet with a super-hydrophobic film layer according to an embodiment of the present disclosure;
FIG. 2 is an AFM surface morphology picture of a glass sheet with a super-hydrophobic film layer according to the above embodiment of the present disclosure;
FIG. 3 is a SEM surface morphology picture of a glass sheet with a super-hydrophobic film layer according to the above embodiment of the present disclosure;
FIG. 4 is a schematic diagram of a change curve of water drop angle in the salt spray test of a glass sheet with a super-hydrophobic film layer according to the above embodiment of the present disclosure;
FIG. 5 is a schematic diagram of a change of water drop angle under an ultraviolet aging test of a glass sheet with super-hydrophobic film layer according to the above embodiment of the present disclosure; and
FIG. 6 is a schematic diagram of a change of water drop angle under a high temperature and high humidity test of a glass sheet with super-hydrophobic film layer according to the above embodiment of the present disclosure.

### DETAILED DESCRIPTION

The following description serves to disclose the disclosure to enable those skilled in the art to practice the present disclosure. The embodiments in the following description are only for examplification. Those skilled in the art may think of other obvious variations. The basic principles of the present disclosure as defined in the following description may be applied to other embodiments, variations, modifications, equivalents, and other technical solutions without departing from the spirit and scope of the present disclosure.

It will be appreciated that the term "a", "an", or "one" is to be understood as "at least one" or "one or more", i.e., in one embodiment, the number of one element may be one and in another embodiment the number of one element may be multiple, and that the term "a", "an", or "one" is not to be construed to limit the number.

According to a super-hydrophobic film layer, a preparation method thereof and a product thereof provided by the present disclosure, the super-hydrophobic film layer may contain Si, O or contain Si, O and H. The super-hydrophobic film layer has a good hydrophobicity and a good light transmittance.

When the super-hydrophobic film layer is formed on a surface of a substrate, the super-hydrophobic film layer enables the substrate to have a good hydrophobicity and a good light transmittance performance. The super-hydrophobic film layer may not cause an excessive influence on light transmittance of the substrate itself, that is, after the transmittance film layer is formed for a transparent substrate, an original light transmittance performance or a similar light transmittance performance can be maintained.

In addition, the super-hydrophobic film layer provided by the present disclosure does not need to be roughened and modified to get a low surface energy respectively, and a rough surface morphology can be formed. The super-hydrophobic film layer has a low surface energy due to methyl dangling bonds, so that it can be formed in one step.

A water contact angle of the super-hydrophobic film layer provided by the present disclosure may be greater than 150°, for example, greater than 156°, and a rolling angle may be less than 10°, for example, less than 5°, or less than 3°.

The present disclosure provides a product with the super-hydrophobic film layer. It should be understood that the product may be made of epoxy laminated material, synthetic resin material, epoxy resin bonded glass fiber fabric, composite epoxy material, polytetrafluoroethylene or other polymer materials, phenolic cotton paper, silicon, glass, ceramics, paper, and the like. The product may be a keyboard, a computer, a mobile phone, a headset, a PSP, an automobile windshield, a camera, a password lock panel. It should be understood by those skilled in the art that this is only an example which does not intend to limit the types of the product.

The product with the super-hydrophobic film layer provided by the present disclosure has an ultraviolet oxidation resistance, a high temperature resistance and a humidity resistance and an acid resistance. For the product with the super-hydrophobic film layer, a color of a substrate itself can be observed through the super-hydrophobic film layer within a certain range of thickness.

According to the method for preparing a super-hydrophobic film layer provided by the present disclosure, the super-hydrophobic film is formed on a surface of a substrate by a plasma enhanced chemical vapor deposition (PECVD) process. That is, in a preparation process, the substrate is exposed in a chamber of a plasma enhanced chemical vapor deposition coating device, plasmas are formed in the chamber, and the reaction raw materials can form the super-hydrophobic film layer on the surface of the substrate by a chemical deposition reaction.

According to the method for preparing a super-hydrophobic film layer provided by the present disclosure, a vacuum vapor introduction method is provided. Since a boiling point of a material is obviously lower at a low vacuum degree than at a normal pressure, raw materials can be transmitted in a quantitative and uniform manner, which is conducive to improving a utilization rate of raw materials and reducing waste discharge.

According to the method for preparing a super-hydrophobic film layer provided by the present disclosure, raw materials do not contain fluoride, which is conducive to reducing environmental pollution and reducing damage to operators.

According to the method for preparing a super-hydrophobic film layer provided by the present disclosure, a process temperature is room temperature, which results in a large application scope of the preparation method and is applicable for many polymer materials, such as PC, PMMA and ABS.

The plasma enhanced chemical vapor deposition (PECVD) process has many advantages over other existing deposition processes: (1) dry deposition to form a uniform film layer without pinholes; (2) the plasma polymerized film has stable chemical and physical properties, such as solvent resistance, chemical corrosion resistance, heat resistance, wear resistance, etc; (3) the plasma polymerized film has a good binding force with substrates; (4) a homogeneous film can also be formed on the surface of extremely irregular substrate; (5) The film can be prepared at a low temperature such as a room temperature to effectively avoid damage to temperature sensitive devices; (6) The plasma process can not only prepare films with a thickness in micrometers, but also prepare ultra-thin nanoscale films.

According to the method for preparing a super-hydrophobic film layer provided by the present disclosure, the method includes:

### (1) cleaning the substrate

the substrate is placed in the cleaning agent for cleaning to remove oil stains on the surface.

### (2) Substrate activation

In an environment of inert gas, the cleaned and dried substrate is placed in a chamber of a PECVD coating device, the chamber is vacuumized, then inert gas is introduced, and a discharge is turned on in the chamber under a certain vacuum degree and a certain voltage to conduct a plasma bombardment activation.

### (3) Forming the super-hydrophobic film layer

The super-hydrophobic film layer is formed on the surface of the substrate by introducing a siloxane monomer and an inert gas under a certain vacuum degree and a certain voltage.

According to an embodiment of the present disclosure, during a process of cleaning the substrate, a cleaning agent may be an organic solvent, such as ethanol or isopropanol. The cleaning agent may also be deionized water. Oil stains on the surface of the substrate can be removed with an ultrasound process.

It should be understood that if the substrate is at a risk of being damaged by ultrasound, it can be cleaned with an organic solvent first, and then is cleaned and activated by plasmas in an activation process of the substrate. Impurities and an oxide layer on the surface of the substrate can be further removed in the process of substrate activation to improve a binding strength between the substrate and the super-hydrophobic film layer formed in a subsequent process.

According to an embodiment of the present disclosure, during a process of cleaning the substrate, the substrate is respectively placed in deionized water and industrial high-purity ethanol or isopropanol for ultrasonic cleaning for 10-20 minutes to remove impurities on the surface of the substrate.

According to an embodiment of the present disclosure, during an activation process of the substrate, the inert gas includes one or more selected from a group consisting of He, Ar and Kr.

According to an embodiment of the present disclosure, during an activation process of the substrate, after the inert gas is introduced, a vacuum degree in a chamber of the PECVD coating device is controllable within a range from 0.1Pa to 50Pa.

The substrate can be fixedly placed at a preset position of the chamber, and the substrate can also be movably placed at a preset position in the chamber.

According to an embodiment of the present disclosure, the PECVD coating device provides a carrier frame placed in the chamber, and the carrier frame may be a rotary frame. The substrate is placed on the rotary frame. When the rotary frame moves relative to the chamber around an axis, the substrate can move relative to the chamber. In this way, the substrate can fully contact with plasmas in the chamber to facilitate the uniformity of coating.

According to an embodiment of the present disclosure, in a process of plasma enhanced chemical vapor deposition (PECVD), plasmas are generated by a glow discharge, and a discharge method can be but is not limited to a microwave discharge, a radio frequency discharge, an ultraviolet discharge, an electric spark discharge, and the like.

According to an embodiment of the present disclosure, the PECVD coating device provides one or more energy sources, which can convert one or more gases into plasmas. The plasmas may include: ionized and neutral introduced gases/precursors, ions, electrons, atoms, free radicals and/or other neutral substances produced by plasmas.

The energy sources may include an ICP (inductively coupled plasma) plasma excitation source or a bias power supply. The carrier frame may be made of conductive materials, and the bias power supply may be conductively coupled with the carrier frame to discharge at the position of the carrier frame. The ICP plasma excitation source can be configured outside the chamber. It is understandable that the configuration position of the energy source described here is just an example. The energy source can also be configured on the inner wall of the chamber or other positions.

According to an embodiment of the present disclosure, during an activation process of the substrate, after the inert gas is introduced, a voltage of a bias power supply can be applied with a range from 10V to 800V, and a power of the ICP can be applied with a range from 50W to 1000W. An activation duration time can be applied with a range from 1min to 30min.

According to an embodiment of the present disclosure, a radio frequency power supply can be used as the power supply of the ICP to generate an alternating magnetic field through an inductive coupling of a coil, thereby resulting in a gas ionization. A rapidly changing magnetic field is conducive to a full and uniform ionization. The bias power supply can be a pulse bias power supply, which ionizes the gas through a glow discharge, and has a directional traction acceleration effect on positive ions. In a process of forming the super-hydrophobic film layer, a dense and high hardness super-hydrophobic film layer can be formed due to a bombardment effect.

The ICP and the bias power supply can be used during the processes. On a basis of obtaining high-level ionized plasmas, the energy of the plasmas reaching the surface of the substrate can be increased, which is conducive to obtaining a dense super-hydrophobic film layer.

The ICP and the bias power supply can be used further to improve a deposition efficiency. The super-hydrophobic film layer can be effectively deposited on the surface of the substrate, and a preparation duration time can be shortened. This is very beneficial to an industrial production of the super-hydrophobic film layer, and to improve its production efficiency.

It should be understood that the ICP plasma source is an example herein. The ICP plasma source can enhance an ionization rate of the monomer by controlling the density of plasmas, so that the super-hydrophobic film layer can be prepared on the surface of the substrate under a negative bias voltage. However, the plasma source of the present disclosure is not limited to ICP.

According to an embodiment of the present disclosure, during a process of substrate activation, the inert gas can be introduced at a flow rate within a range from 10sccm to 1000sccm.

According to an embodiment of the present disclosure, the siloxane monomer may be a chain siloxane compound or a cyclic siloxane compound.

According to an embodiment of the present disclosure, the siloxane monomer may be a hydrocarbyl siloxane, a chain siloxane compound, or a cyclic siloxane compound.

According to an embodiment of the present disclosure, the siloxane monomer has a following structure:

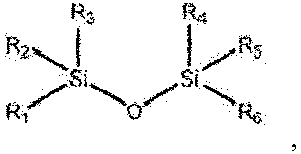

Each of R₁ to R₆ is independently selected from C₁-C₆ alkyl, C₂-C₆ alkenyl or hydrogen, and at least one of R₁ to R₆ is not hydrogen. Optionally, each of R₁ to R₆ is independently selected from C₁-C₃ alkyl, C₂-C₄ alkenyl or hydrogen, such as methyl, ethyl, vinyl, allyl, or hydrogen, and at least one of R₁ to R₆ is not hydrogen. Optionally, at least two or three (for example, four, five, or six) of R₁ to R₆ are not hydrogen. Optionally, at least one of R₁ to R₆ has hydrocarbyl.

Optional examples of the siloxane monomer may include hexamethyldisiloxane (HMDSO), tetramethyldisiloxane (TMDSO), hexaethyldisiloxane, 1,1,3,3-tetramethyldisiloxane, 1,3-diethyltetramethyldisiloxane (DVTMDSO), and hexavinyldisiloxane (HVDSO).

According to an embodiment of the present disclosure, the siloxane monomer has a following structure:

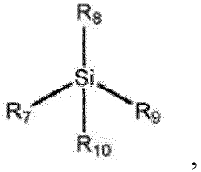

Each of R₇ to R₁₀ is independently selected from C₁-C₆ alkyl, C₁-C₆ alkoxy, C₂-C₆ alkenyl or hydrogen, and at least one of R₇ to R₁₀ is not hydrogen and at least one of R₇ to R₁₀ has oxygen to form a silicon-oxygen bond. Optionally, each of R₇ to R₁₀ is independently selected from C₁-C₃ alkyl, C₁-C₃ alkoxy, C₂-C₄ alkenyl or hydrogen, and at least one of R₇ to R₁₀ is not hydrogen. Optionally, at least two of R₇ to R₁₀ are not hydrogen, for example, three or four of R₇ to R₁₀ are not hydrogen. Optionally, at least one of R₇ to R₁₀ has hydrocarbyl.

Optional examples of the siloxane monomer may include tetramethoxysilane, tetrapropoxysilane, allyl trimethoxysilane (ATMOS), tetraethyl orthosilicate (TEOS), 3-(diethylamino) propyl trimethoxysilane, trimethylsiloxane and triisopropylsiloxane.

According to an embodiment of the present disclosure, the siloxane monomer has a following structure:

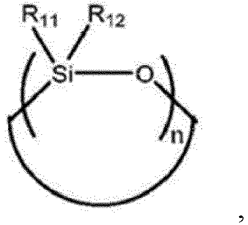

n is 3 or 4, each of Rn and R₁₂ is independently selected from C₁-C₆ alkyl, C₂-C₆ alkenyl or hydrogen, and at least one of R₁₁ and R₁₂ is not hydrogen. Optionally, each of R₁₁ and R₁₂ is independently selected from C₁-C₃ alkyl, C₂-C₄ alkenyl or hydrogen, such as methyl, ethyl, vinyl, allyl, or hydrogen, and at least one of R₁₁ and R₁₂ is not hydrogen. Optionally, at least one of R₁₁ and R₁₂ has hydrocarbyl.

Optional examples of the siloxane monomer may include trimethylcyclotrisiloxane, triethyltrimethylcyclotrisiloxane (V₃D₃), tetraethyltetramethylcyclotetrasiloxane (V₄D₄), tetramethylcyclotetrasiloxane (TMCS) and octamethylcyclotetrasiloxane (OMCTS), hexamethylcyclotrisiloxane, dodecylcyclohexasiloxane, decamethylcyclopentasiloxane, and dodecylcyclohexane siloxane.

According to an embodiment of the present disclosure, the siloxane monomer includes one or more selected from a group consisting of: hexamethyldisiloxane, tetramethyldisiloxane, hexaethyldisiloxane, 1,1,3,3-tetramethyldisiloxane, tetramethoxysilane, tetraethoxysilane, tetrapropoxysilane, allyl trimethoxysilane, trimethylcyclotrisiloxane, hexamethylcyclotrisiloxane, octamethylcyclotetrasiloxane, tetramethyltetravinylcyclotetrasiloxane, dodecylcyclohexasiloxane, and decamethylcyclopentasiloxane.

According to an embodiment of the present disclosure, the siloxane monomer is introduced through a vacuum liquid phase evaporation device. The siloxane monomer can be controlled in quantity and vaporized to form a vapor at a relatively low temperature to enter the chamber of the PECVD coating device. The vacuum liquid phase evaporation device can be provided with a diaphragm valve to control the siloxane monomer in quantity. Since the introducing amount of the siloxane monomer can be precisely controlled, it is beneficial to enhance the deposition stability of the super-hydrophobic film layer during the preparation process, as well as to improve a utilization rate of the siloxane monomer. The vacuum liquid phase evaporation device can control the introducing amount with a diaphragm valve. After entering the vacuum liquid phase evaporation device, the siloxane monomer is evaporated at a temperature ranging from 50°C to 150°C and then is introduced to the chamber. In the vacuum liquid phase evaporation device, the boiling point of the siloxane monomer is obviously lower than that at the atmospheric pressure, and the siloxane monomer can be uniformly and quantitatively introduced to the chamber.

According to an embodiment of the present disclosure, in a process of forming the super-hydrophobic film layer, a flow rate of the siloxane monomer can be controlled to range from 20µL/min to 2000µL/min.

According to an embodiment of the present disclosure, in a process of forming the super-hydrophobic film layer, the inert gas includes one or more selected from a group consisting of He, Ar and Kr. It should be understood that the inert gas used in a process of substrate activation and a process for forming the super-hydrophobic film layer can be the same or different.

According to an embodiment of the present disclosure, in a process of forming the super-hydrophobic film layer, a vacuum pressure of the chamber is controlled to range from 0.1Pa to 80Pa, a bias voltage is controlled to range from 50V to 1000V, and an ICP power is controlled to range from 100W to 1000W.

According to an embodiment of the present disclosure, in a process of forming the super-hydrophobic film layer, a coating duration time is controlled in a range of 60s to 2000s, and a thickness of the super-hydrophobic film layer ranges from 5nm to 3500nm. According to the preparation method, the coating can be formed in a short time, and a plurality of substrates can be placed in the PECVD coating device, so that large-scale batch coating can be formed in a short time at a low temperature.

It should be noted that the PECVD coating device is equipped with an exhaust gas filter device, and exhaust gases generated after the reaction can be filtered through the exhaust gas filter device to reduce the pollution to the external environment.

It should be noted that the substrate needs to be transmitted between the process of cleaning the substrate (1) and the process of surface activation of the substrate (2), and no other special transmitting is needed between other processes in the entire preparation process. The industrialization processes can be reduced, which is conducive to a quantity production of the super-hydrophobic film layer.

### Embodiment One

In step one, the substrate was cleaned.

A glass sheet was placed respectively in deionized water and industrial ethanol for ultrasonic cleaning for 10 minutes to remove oil stains on the surface.

In step two, substrate activation was performed.

The glass sheet was loaded into a chamber of the PECVD coating device after being cleaned and dried, and the chamber was pumped to get a vacuum degree being less than 1×10⁻²Pa. Argon gas was introduced at a flow rate of 100sccm, and the vacuum degree was kept at 2Pa. A bias voltage of 300V was applied on a rotary frame, an ICP power was set to be 600W, and a plasma bombardment was conducted for 10 minutes to increase the surface activity of the glass sheet.

In step three, the super-hydrophobic film layer was formed.

A vapor of hexamethyldisiloxane monomer was introduced at a flow rate of 200µL/min, and argon gas was introduced at a flow rate of 100sccm at the same time. A butterfly valve was adjusted to keep a vacuum degree at 6Pa, a bias voltage of 600V was applied on the rotary frame, an ICP power was set to be 800W, and the coating duration time was 300s. Therefore, the super-hydrophobic film layer was formed.

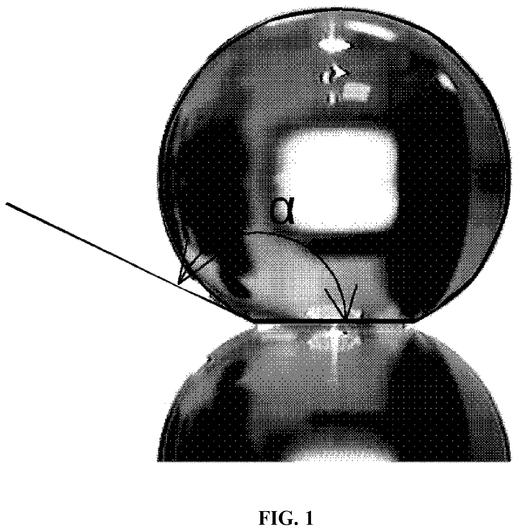

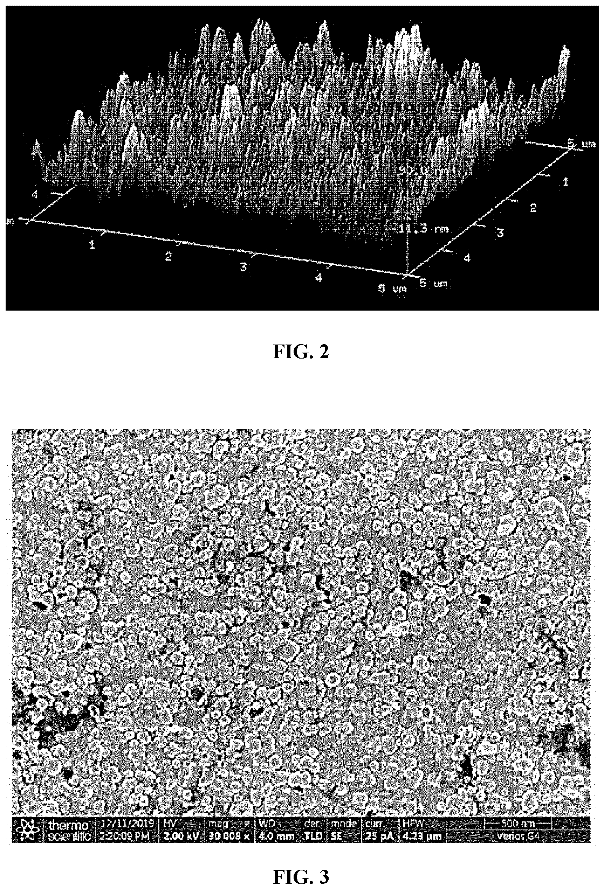

A thickness of the super-hydrophobic film layer prepared in Embodiment One was 70nm, and a water contact angle was measured to be more than 154°. Water drops would roll away if they were slightly shaken. A picture of the water contact angle is shown in FIG. 1. FIG. 2 and FIG. 3 show the AFM and SEM surface morphology pictures of the super-hydrophobic film layer respectively.

A rolling angle of the super-hydrophobic film layer prepared in Embodiment One was less than 3°.

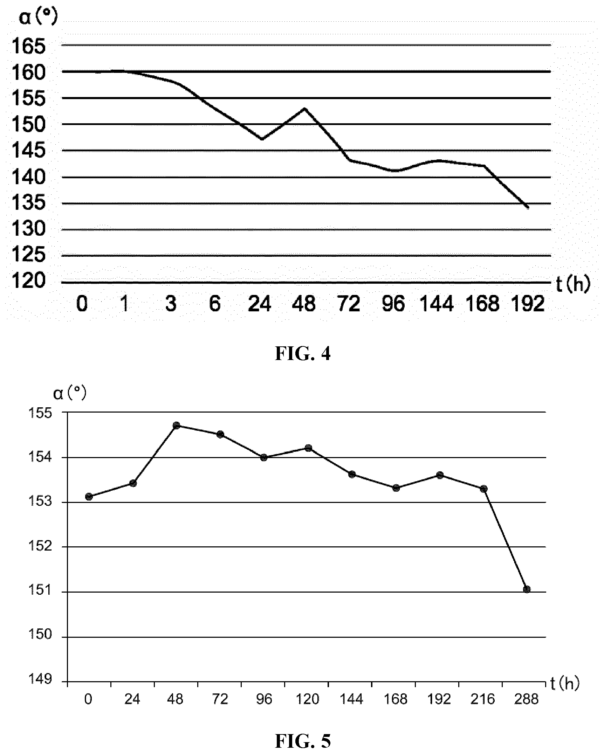

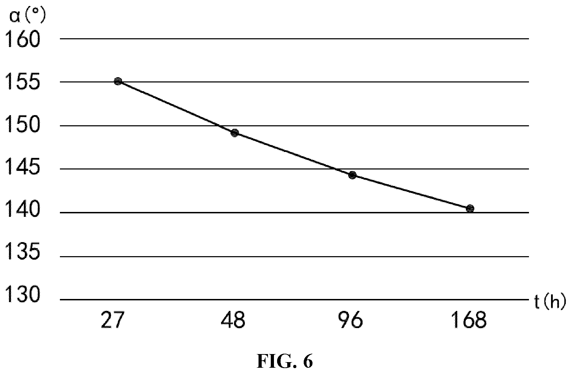

A light transmittance of the glass sheet provided with the super-hydrophobic film layer was reduced by less than 0.5%. Further, an ultraviolet aging test (0.35W/m²; temperature of about 50°C; an internal water tank; blackboard set temperature of 50°C, actual temperature of about 47°C), a high temperature and high humidity (85°C, 85%RH) test and a salt spray (5% NaCl solution, 35°C, 1Kg/cm²) test of the super-hydrophobic film layer were performed respectively, as shown in FIG. 4 to FIG. 6.

### Embodiment Two

In step one, the substrate was cleaned.

A PC sheet was placed respectively in deionized water and industrial ethanol for ultrasonic cleaning for 10 minutes to remove oil stains on the surface.

In step two, substrate activation was performed.

The PC sheet was loaded into a chamber of the PECVD coating device after being cleaned and dried with nitrogen gas, and the chamber was pumped to get a vacuum degree being less than 1×10⁻²Pa. Argon gas was introduced at a flow rate of 100sccm, and the vacuum degree was kept at 2Pa. A bias voltage of 300V was applied on a rotary frame, an ICP power was set to be 600W, and a plasma bombardment was conducted for 5 minutes to increase the surface activity of the PC sheet.

In step three, the super-hydrophobic film layer was formed.

A vapor of tetramethyltetravinylcyclotetrasiloxane monomer was introduced at a flow rate of 200µL/min, and argon gas was introduced at a flow rate of 100sccm at the same time. A butterfly valve was adjusted to keep a vacuum degree at 5Pa, a bias voltage of 300V was applied on the rotary frame, an ICP power was set to be 500W, and the coating duration time was 500s. Therefore, the super-hydrophobic film layer was formed.

A thickness of the super-hydrophobic film layer prepared in Embodiment Two was 125nm, and a water contact angle was measured to be more than 158°.

### Embodiment Three

In step one, the substrate was cleaned.

A glass sheet was placed respectively in deionized water and industrial ethanol for ultrasonic cleaning for 10 minutes to remove oil stains on the surface.

In step two, substrate activation was performed.

The glass sheet was loaded into a chamber of the PECVD coating device after being cleaned and dried with nitrogen gas, and the chamber was pumped to get a vacuum degree being less than 1×10⁻²Pa. Argon gas was introduced at a flow rate of 100sccm, and the vacuum degree was kept at 2Pa. A bias voltage of 300V was applied on a rotary frame, an ICP power was set to be 500W, and a plasma bombardment was conducted for 5 minutes to increase the surface activity of the glass sheet.

In step three, the super-hydrophobic film layer was formed.

A vapor of dodecylcyclohexasiloxane monomer was introduced at a flow rate of 300µL/min, and argon gas was introduced at a flow rate of 100sccm at the same time. A butterfly valve was adjusted to keep a vacuum degree at 8Pa, a bias voltage of 600V was applied on the rotary frame, an ICP power was set to be 800W, and the coating duration time was 500s. Therefore, the super-hydrophobic film layer was formed.

A thickness of the super-hydrophobic film layer prepared in Embodiment Three was 155nm, and a water contact angle was measured to be more than 156°.

### Embodiment Four

In step one, the substrate was cleaned.

A glass sheet was placed respectively in deionized water and industrial ethanol for ultrasonic cleaning for 10 minutes to remove oil stains on the surface.

In step two, substrate activation was performed.

The glass sheet was loaded into a chamber of the PECVD coating device after being cleaned and dried with nitrogen gas, and the chamber was pumped to get a vacuum degree being less than 1×10⁻²Pa. Argon gas was introduced at a flow rate of 100sccm, and the vacuum degree was kept at 2Pa. A bias voltage of 300V was applied on a rotary frame, an ICP power was set to be 600W, and a plasma bombardment was conducted for 5 minutes to increase the surface activity of the glass sheet.

In step three, the super-hydrophobic film layer was formed.

A vapor of decamethylcyclopentasiloxane monomer was introduced at a flow rate of 350µL/min, and argon gas was introduced at a flow rate of 150sccm at the same time. A butterfly valve was adjusted to keep a vacuum degree at 8Pa, a bias voltage of 600V was applied on the rotary frame, an ICP power was set to be 700W, and the coating duration time was 500s. Therefore, the super-hydrophobic film layer was formed.

A thickness of the super-hydrophobic film layer prepared in Embodiment Four was 175nm, and a water contact angle was measured to be more than 156°.

### Embodiment Five

In step one, the substrate was cleaned.

A glass sheet was placed respectively in deionized water and industrial ethanol for ultrasonic cleaning for 10 minutes to remove oil stains on the surface.

In step two, substrate activation was performed.

The glass sheet was loaded into a chamber of the PECVD coating device after being cleaned and dried with nitrogen gas, and the chamber was pumped to get a vacuum degree being less than 1×10⁻²Pa. Helium gas was introduced at a flow rate of 100sccm, and the vacuum degree was kept at 2Pa. A bias voltage of 300V was applied on a rotary frame, an ICP power was set to be 600W, and a plasma bombardment was conducted for 5 minutes to increase the surface activity of the glass sheet.

In step three, the super-hydrophobic film layer was formed.

A vapor of trimethylcyclotrisiloxane monomer was introduced at a flow rate of 400µL/min, and helium gas was introduced at a flow rate of 120sccm at the same time. A butterfly valve was adjusted to keep a vacuum degree at 8Pa, a bias voltage of 600V was applied on the rotary frame, an ICP power was set to be 700W, and the coating duration time was 500s. Therefore, the super-hydrophobic film layer was formed.

A thickness of the super-hydrophobic film layer prepared in Embodiment Five was 200nm, and a water contact angle was measured to be more than 158°.

### Embodiment Six

In step one, the substrate was cleaned.

A glass sheet was placed respectively in deionized water and industrial ethanol for ultrasonic cleaning for 10 minutes to remove oil stains on the surface.

In step two, substrate activation was performed.

The glass sheet was loaded into a chamber of the PECVD coating device after being cleaned and dried with nitrogen gas, and the chamber was pumped to get a vacuum degree being less than 1×10⁻²Pa. Argon gas was introduced at a flow rate of 100sccm, and the vacuum degree was kept at 2Pa. A bias voltage of 300V was applied on a rotary frame, an ICP power was set to be 600W, and a plasma bombardment was conducted for 5 minutes to increase the surface activity of the glass sheet.

In step three, the super-hydrophobic film layer was formed.

A vapor of tetraethoxysilane monomer was introduced at a flow rate of 500µL/min, and argon gas was introduced at a flow rate of 150sccm at the same time. A butterfly valve was adjusted to keep a vacuum degree at 8Pa, a bias voltage of 600V was applied on the rotary frame, an ICP power was set to be 700W, and the coating duration time was 500s. Therefore, the super-hydrophobic film layer was formed.

A thickness of the super-hydrophobic film layer prepared in Embodiment Six was 260nm, and a water contact angle was measured to be more than 157°.

Those skilled in the art will appreciate that, the embodiments of the present disclosure shown in the foregoing description and the accompanying drawings are by way of example only and are not intended to limit the present disclosure. The object of the present disclosure has been completely and effectively realized. The functionality and structural principles of the present disclosure have been shown and illustrated in the embodiments, and the embodiments of the disclosure may be varied or modified without departing from the principles described herein.

## Claims

1. A method for preparing a super-hydrophobic film layer, comprising:
introducing a siloxane monomer serving as a reaction raw material into a PECVD coating device to form a super-hydrophobic film layer on a surface of a substrate by a plasma enhanced chemical vapor deposition.

2. The method according to claim 1, wherein a light transmittance of the substrate before the formation of the super-hydrophobic film layer and after the formation of the super-hydrophobic film layer changes by no more than 1%.

3. The method according to claim 1 or claim 2, further comprising: introducing an inert gas and turning on a plasma discharge to bombard the surface of the substrate with plasma before forming the super-hydrophobic film layer.

4. The method according to claim 1 or claim 2, further comprising: in a process of forming the super-hydrophobic film layer, introducing an inert gas as an auxiliary gas.

5. The method according to claim 1 or claim 2, wherein the PECVD coating device takes an ICP source as a plasma source.

6. The method according to claim 5, wherein a bias voltage is applied to a chamber of the PECVD coating device, and the substrate is placed in the chamber.

7. The method according to claim 1 or claim 2, wherein the substrate is placed on a rotary frame so as to be movable during a coating process.

8. The method according to claim 3, wherein the plasma bombardment comprises:
pumping to get a vacuum degree in a chamber of the PECVD coating device being not greater than 1×10⁻¹Pa, wherein the substrate is placed in the chamber; and
introducing the inert gas, wherein a bias voltage ranging from 10V to 800V is applied in the chamber, an ICP source power is controlled to range from 50W to 1000W, and a vacuum degree is controlled to range from 0.1Pa to 50Pa for a plasma bombardment activation.

9. The method according to claim 1 or claim 2, wherein a process of forming the super-hydrophobic film layer comprises:
introducing a vapor of a siloxane monomer and an inert gas, wherein a flow rate of the siloxane monomer ranges from 20µL/min to 2000µL/min, and a flow rate of the inert gas ranges from 10sccm to 1000sccm, a bias voltage ranging from 50V to 1000V is applied in a chamber of the PECVD coating device, an ICP source power is controlled to range from 100W to 1000W and a vacuum degree is controlled to range from 0.1Pa to 80Pa to form the super-hydrophobic film layer on the surface of the substrate placed in the chamber.

10. The method according to claim 1 or claim 2, wherein the siloxane monomer is a hydrocarbon siloxane compound, and a methyl dangling bond is formed on the surface of the substrate during a reaction process to reduce a surface energy of the surface of the substrate.

11. The method according to claim 1 or claim 2, wherein the siloxane monomer comprises one or more selected from a group consisting of: hexamethyldisiloxane, tetramethyldisiloxane, hexaethyldisiloxane, 1,1,3,3-tetramethyldisiloxane, tetramethoxysilane, tetraethoxysilane, tetrapropoxysilane, allyl trimethoxysilane, trimethylcyclotrisiloxane, hexamethylcyclotrisiloxane, octamethylcyclotetrasiloxane, tetramethyltetravinylcyclotetrasiloxane, dodecylcyclohexasiloxane, and decamethylcyclopentasiloxane.

12. The method according to claim 1 or claim 2, wherein the siloxane monomer has a following structure: 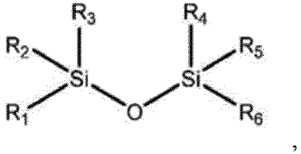 wherein each of R₁ to R₆ independently comprises one selected from a group consisting of C₁-C₆ alkyl, C₂-C₆ alkenyl and hydrogen, at least one of the R₁ to R₆ is not hydrogen, and at least one of the R₁ to R₆ has hydrocarbyl.

13. The method according to claim 1 or claim 2, wherein the siloxane monomer has a following structure: 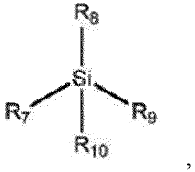 wherein each of R₇ to R₁₀ independently comprises one selected from a group consisting of C₁-C₆ alkyl, C₁-C₆ alkoxy, C₂-C₆ alkenyl and hydrogen, at least one of the R₇ to R₁₀ is not hydrogen, at least one of the R₇ to R₁₀ has oxygen to form a silicon-oxygen bond, and at least one of the R₇ to R₁₀ has hydrocarbyl.

14. The method according to claim 1 or claim 2, wherein the siloxane monomer has a following structure: 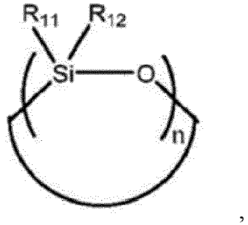 wherein n is 3 or 4, each of R₁₁ and R₁₂ independently comprises one selected from a group consisting of C₁-C₆ alkyl, C₂-C₆ alkenyl and hydrogen, at least one of the R₁₁ and R₁₂ is not hydrogen, and at least one of the R₁₁ and R₁₂ has hydrocarbyl.

15. The method according to claim 1 or claim 2, wherein a water contact angle of the super-hydrophobic film layer is greater than 150°.

16. A product with a super-hydrophobic film layer, wherein a surface of the product is provided with the super-hydrophobic film layer, and the super-hydrophobic film layer is formed on the surface of the product by a plasma enhanced chemical vapor deposition using a siloxane monomer as a reaction raw material.

17. The product according to claim 16, wherein the product comprises one or more selected from a group consisting of: an electronic product, a silk product, a metal product, a glass product, a ceramic product and a plastic product.

18. The product according to claim 16, wherein a light transmittance of the product before the formation of the super-hydrophobic film layer and after the formation of the super-hydrophobic film layer changes by no more than 1%.

19. The product according to claim 16, wherein an inert gas is introduced and a plasma discharge is turned on to bombard the surface of the product with plasma before forming the super-hydrophobic film layer.

20. The product according to claim 16, wherein, in a process of forming the super-hydrophobic film layer, an inert gas is introduced as an auxiliary gas.

21. The product according to claim 16, wherein, in a process of forming the super-hydrophobic film layer, an ICP source is used as a plasma source.

22. The product according to claim 16, wherein, in a process of forming the super-hydrophobic film layer, a bias voltage is applied to an environment where the product is placed.

23. The product according to claim 16, wherein, in a process of forming the super-hydrophobic film layer, the product is placed on a rotary frame so as to be movable during a coating process.

24. The product according to claim 16, wherein, in a process of forming the super-hydrophobic film layer, the siloxane monomer is a hydrocarbon siloxane compound, and a methyl dangling bond is formed on a surface of a substrate during a reaction process to reduce a surface energy of the surface of the substrate.

25. The product according to claim 16, wherein the siloxane monomer comprises one or more selected from a group consisting of: hexamethyldisiloxane, tetramethyldisiloxane, hexaethyldisiloxane, 1,1,3,3-tetramethyldisiloxane, tetramethoxysilane, tetraethoxysilane, tetrapropoxysilane, allyl trimethoxysilane, trimethylcyclotrisiloxane, hexamethylcyclotrisiloxane, octamethylcyclotetrasiloxane, tetramethyltetravinylcyclotetrasiloxane, dodecylcyclohexasiloxane, and decamethylcyclopentasiloxane.

26. The product according to claim 16, wherein the siloxane monomer is hexamethyldisiloxane.

27. The product according to claim 16, wherein the siloxane monomer is tetramethyltetravinylcyclotetrasiloxane.

28. The product according to claim 16, wherein the siloxane monomer is dodecylcyclohexasiloxane.

29. The product according to claim 16, wherein the siloxane monomer is decamethylcyclopentasiloxane.

30. The product according to claim 16, wherein the siloxane monomer is trimethylcyclotrisiloxane.

31. The product according to claim 16, wherein the siloxane monomer is tetraethoxysilane.

32. The product according to claim 16, wherein the siloxane monomer has a following structure: 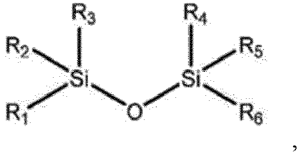 wherein each of R₁ to R₆ independently comprises one selected from a group consisting of C₁-C₆ alkyl, C₂-C₆ alkenyl and hydrogen, at least one of the R₁ to R₆ is not hydrogen, and at least one of the R₁ to R₆ has hydrocarbyl.

33. The product according to claim 16, wherein the siloxane monomer has a following structure: 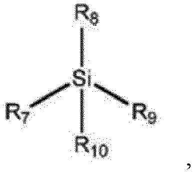 wherein each of R₇ to R₁₀ independently comprises one selected from a group consisting of C₁-C₆ alkyl, C₁-C₆ alkoxy, C₂-C₆ alkenyl and hydrogen, at least one of the R₇ to R₁₀ is not hydrogen, at least one of the R₇ to R₁₀ has oxygen to form a silicon-oxygen bond, and at least one of the R₇ to R₁₀ has hydrocarbyl.

34. The product according to claim 16, wherein the siloxane monomer has a following structure: 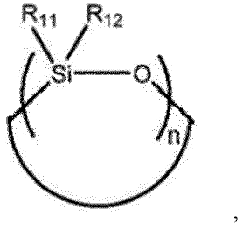 wherein n is 3 or 4, each of R₁₁ and R₁₂ independently comprises one selected from a group consisting of C₁-C₆ alkyl, C₂-C₆ alkenyl and hydrogen, at least one of the R₁₁ and R₁₂ is not hydrogen, and at least one of the R₁₁ and R₁₂ has hydrocarbyl.

35. The product according to any one of claims from claim 16 to claim 34, wherein a water contact angle of the super-hydrophobic film layer is greater than 150°.
